(19) Europäisches Patentamt
European Patent Office
Office européen des brevets

(11) **EP 1 027 614 B1**

(12) **EUROPÄISCHE PATENTSCHRIFT**

(45) Veröffentlichungstag und Bekanntmachung des Hinweises auf die Patenterteilung:
**16.01.2002   Patentblatt 2002/03**

(21) Anmeldenummer: **98961055.5**

(22) Anmeldetag: **30.10.1998**

(51) Int Cl.⁷: **G01R 31/28**

(86) Internationale Anmeldenummer:
**PCT/DE98/03181**

(87) Internationale Veröffentlichungsnummer:
**WO 99/23500 (14.05.1999 Gazette 1999/19)**

(54) **VERFAHREN ZUM TESTEN ELEKTRISCHER BAUGRUPPEN**

METHOD FOR TESTING ELECTRICAL MODULES

PROCEDE D'ESSAI D'ENSEMBLES ELECTRIQUES

(84) Benannte Vertragsstaaten:
**DE FR GB IT**

(30) Priorität: **30.10.1997   DE 19748029**

(43) Veröffentlichungstag der Anmeldung:
**16.08.2000   Patentblatt 2000/33**

(73) Patentinhaber: **SIEMENS AKTIENGESELLSCHAFT 80333 München (DE)**

(72) Erfinder: **VUKSIC, Antun D-81739 München (DE)**

(56) Entgegenhaltungen:
**US-A- 5 006 808          US-A- 5 504 432**

- **PATENT ABSTRACTS OF JAPAN vol. 011, no. 002 (P-532), 6. Januar 1987 & JP 61 180153 A (KIKUSUI DENSHI KOGYO KK), 12. August 1986**
- **PATENT ABSTRACTS OF JAPAN vol. 098, no. 001, 30. Januar 1998 & JP 09 230005 A (HIOKI EE CORP), 5. September 1997**

# EP 1 027 614 B1

**Beschreibung**

Die Erfindung betrifft ein Verfahren zum Testen elektrischer Baugruppen gemäß dem Oberbegriff des Anspruchs 1.

Elektrische Baugruppen müssen vor ihrer Freigabe getestet werden. Eine bekannte Testmaschine ist der sogenannte Flying-Probe Tester, auf dem die zu testenden elektrischen Baugruppen ohne Versorgungsspannung getestet werden.

Der Flying-Probe Tester weist zum Herstellen elektrischer Kontakte mit Kontaktierungspunkten der zu testenden elektrischen Baugruppe Kontaktierungselemente auf. Die Kontaktierungselemente "fliegen" nahezu, wie der Name der Testmaschine schon andeutet, über der zu testenden elektrischen Baugruppe gesteuert von einem Testprogramm hin und her und kontaktieren nacheinander jeweils vorgegebene Gruppen von Kontaktpunkten auf der zu testenden elektrischen Baugruppe, um an ihnen elektrische Größen wie Widerstand, Kapazität und Induktivität zu messen. Das Testprogramm diagnostiziert dann anhand der gemessenen Werte in Abhängigkeit vom Ort der gemessenen Werte Kurzschlüsse zwischen Leitungsnetzen sowie falsch, gar nicht bestückte oder nicht richtig kontaktierte Bauelemente auf der zu testenden elektrischen Baugruppe. Die Vorgänge, wie sie oben beschrieben sind, laufen in sogenannten Kurzschluss- und Bauelementetests ab, und so werden sie nachfolgend auch öfters bezeichnet.

Innerhalb der Tests können die einzelnen Testarten wie in der nachfolgenden Auflistung angegeben gegliedert sein:

1. Kurzschlusstest
2. Bauelementetest
3. Opentest, das heißt, Test auf fehlende Bauelemente oder nicht richtig kontaktierte Bauelemente.

Für die weiteren Ausführungen wird das Schwergewicht auf die Kurzschluss- und Bauelementetests gelegt.

Für die Tests müssen von der Testmaschine sogenannte Bewegungsschritte ausgeführt werden. Bewegungsschritte sind Schritte, in denen die Testmaschine die Kontaktierungselemente zu den zu kontaktierenden Gruppen von Kontaktierungspunkten auf der zu testenden elektrischen Baugruppe bringt und kontaktiert. Nachdem die Kontakte hergestellt sind, führt die Testmaschine einen oder mehrere Prüfschritte durch, in denen sie eine oder mehrere der oben genannten elektrischen Größen misst und sie in Abhängigkeit vom Ort der Messung auswertet.

Je nach Art von elektrischen Baugruppen können elektrische Baugruppen im Schnitt 200 Widerstands-, Kapazitäts- und Induktivitäts-Bauelemente aufweisen und 500 Leitungsnetze haben, durch die die Bauelemente miteinander verbunden sind. Ein Leitungsnetz umfasst sowohl die Leitungen zu den einzelnen Bauelementen als Verbindungselement zwischen den Bauelementen als auch die Bauelementepins mit allen bauelementeintern galvanisch angeschlossenen Elementen.

Ferner können diese elektrischen Baugruppen derartig auf der elektrischen Baugruppe angeordnete Leitungsnetze haben, dass im Schnitt ein Leitungsnetz jeweils 5 benachbarte Leitungsnetze hat, mit denen jeweils ein Kurzschluss passieren kann.

In bisherigen Kurzschluss- und Bauelementetestverfahren werden, um die Kurzschlussfreiheit sicher zu stellen, Messungen zwischen allen Leitungsnetzen und jeweils allen pro Leitungsnetz für einen Kurzschluss in Frage kommenden Leitungsnetzen durchgeführt. Anschließend kommen dann die Messungen, um den Bauelementetest durchzuführen. Für jede Messung, insbesondere für jede Messung in der Kurzschlusstestphase, wird ein eigener Bewegungsschritt ausgeführt. In Bezug auf das oben angesprochene Beispiel einer bestimmten Art von elektrischen Baugruppen bedeutet dies an Bewegungsschritten für den Kurzschluss- und Bauelementetest:

| (500 LN) * (5 benachbarte LN) = | 2 500 für Kurzschlusstest |
|---|---|
| 200 Bauelemente = | 200 für Elementetest. |
| LN bedeutet: Leitungsnetz. | |

Die vom Flying-Probe Tester zu absolvierenden Bewegungsschritte belaufen sich daher auf 2 700 Bewegungsschritte.

Durch die mechanischen Bewegungen der Kontaktierungselemente ist der Flying-Probe Tester nicht besonders schnell. Trotzdem eignet er sich gut für elektrische Baugruppen, die in kleineren Stückzahlen aufgelegt werden, um diese Kurzschluss- und Bauelementetests zu unterwerfen. Der Flying-Probe Tester ist relativ schnell und einfach zu programmieren und daher für diese Art von elektrischen Baugruppen wertvoll.

Aus dem Dokument US-A-5 006 808 ist eine Prüfmethode für unbestückte Baugruppen bekannt, bei der zur Prüfung ein Flying-Probe Tester eingesetzt wird. Die Hauptprüfung der Baugruppe erfolgt über Kapazitätsmessungen zwischen den einzelnen Leitungsnetzen. Zeigen die Messungen unerwartete Werte, werden ergänzend Widerstandsmessungen durchgeführt. Die bekannte Prüfmethode ermöglicht nicht mit relativ wenigen Prüfschritten die Prüfung beliebig bestückter Baugruppen.

Aus dem Dokument JP-A-61 180 153 ist eine Prüfmethode für die Prüfung bestückter Baugruppen bekannt. Die Prüfung erfolgt allerdings nicht durch einen Flying-Probe Tester. Außerdem weisen die dort zu prüfenden Baugruppen nur Leitungsnetze auf, die messbare Widerstände haben. Kapazitive und/oder induktive Messungen werden hier nicht in Betracht gezogen. Damit ist der hier aufgezeigte Stand der Technik auf die Prüfung von Widerstandsnetzen beschränkt. Eine Prüfung beliebig bestückter Baugruppen mit relativ wenigen Prüfschritten ist auch mit diesem Stand der Technik nicht möglich.

Aufgabe der vorliegenden Erfindung ist es daher, ausgehend von einem Verfahren der eingangs genannten Art die Anzahl der Bewegungsschritte beim Kurzschluss- und Bauelementetest von beliebig bestückten elektrischen Baugruppen bei Aufrechterhaltung der vollständigen Kurzschlussfreiheit zu verringern.

Diese Aufgabe wird gelöst durch die Merkmale im kennzeichnenden Teil des Anspruchs 1.

Danach wird die Anzahl der Bewegungsschritte beim Kurzschlusstest auf die einfache Anzahl der vorhandenen Leitungsnetze beschränkt. Wird mit diesen Bewegungsschritten kein Fehler entdeckt, ist damit automatisch insgesamt die Kurzschlussfreiheit sichergestellt. Die Kurzschlussfreiheit wurde vormals erst durch Messen zwischen allen jeweils benachbarten Leitungsnetzen erhalten. Grund für die Beschränkung auf die paar Bewegungsschritte ist die Möglichkeit von Kurzschlussaussagen anhand der bei Messungen an den jeweiligen einzelnen Leitungsnetzen bezogen auf einen vorhandenen Massebezugspunkt bzw. auf ein jeweils zugehöriges Bezugspotential erhaltenen elektrischen Größen. Außerdem werden bei der Gelegenheit dieser Messungen ohne zusätzlichen Bewegungsschritten in gewissem Umfang Bauelemente entweder gleich unmittelbar oder aber lediglich durch einen weiteren Prüfschritt mit einer geringfügigen zusätzlichen Messzeit, beispielsweise neben einer Prüfung auf einen vorgegebenen Widerstandswert auch eine Prüfung auf einen vorgegebenen Kapazitätswert, mitgetestet. Es sind somit für den Erhalt jeder dieser Informationen nicht jeweils eigene Bewegungsschritte nötig. Diese sind erst nötig, wenn besondere Fehlerkonstellationen vorliegen, um den Fehler dann diagnostizieren zu können. Da davon ausgegangen werden kann, dass in einer Fertigung ein hoher Grad an Fertigungsqualität vorherrscht, sind solche zusätzlichen Messungen nur selten notwendig. Zusätzliche Messungen waren im übrigen bei der bisherigen Kurzschlusstestmethode Bestandteil des Messprogramms. Die erfindungsgemäße Methode des Kurzschluss- und Bauelementetests hat außerdem den Vorteil, dass die Prüfzeit dadurch kurz gehalten werden kann, dass bei der Abarbeitung der einzelnen Messungen an den jeweiligen, auf Masse/Potential bezogenen Leitungsnetzen insgesamt ein optimaler Weg eingehalten werden kann, das heißt, ein Weg, der insgesamt eine kürzeste Wegstrecke einschließt.

Vorteilhafte Ausgestaltungen der Erfindung sind Gegenstand von Unteransprüchen.

Danach können zwar in besonderen Fehlerfällen ergänzende Prüfschritte mit jeweils eigenen Bewegungsschritten notwendig sein. Diese bleiben aber auf diejenigen Leitungsnetze beschränkt, bei denen die Fehlerfälle aufgetreten sind. Es müssen daher nur ein paar ergänzende Prüf- und Bewegungsschritte durchgeführt werden.

Der Umstand, dass immer mit einem gleichen Bezugspunkt (Masse/Potential) die Prüfungen durchgeführt werden, hat den Vorteil, dass ein einziges Kontaktierungselement für jeweils alle Prüfungen im Zusammenhang mit diesem Bezugspunkt verwendet werden kann. Das heißt, das diesem Bezugspunkt zugeordnete Kontaktierungselement kann während der verschiedenen Messungen ohne Bewegungsschritt an dem Bezugspunkt gehalten werden.

Für die Durchführung der einzelnen Prüfschritte genügen die an sich bekannten einfachen Methoden der Widerstands-, Kapazitäts- und der Induktivitätsmessung, so dass gegenüber bisher kein erhöhter Aufwand für das Messen erforderlich ist.

Nachfolgend wird die Erfindung anhand einer Zeichnung näher erläutert. Darin zeigen

Figur 1    ein Paar jeweils allein mit Widerständen aufgebaute Leitungsnetze mit einer angedeuteten Kurzschlussverbindung und

Figur 2    ein Paar jeweils allein mit Kondensatoren aufgebaute Leitungsnetze mit einer angedeuteten Kurzschlussverbindung.

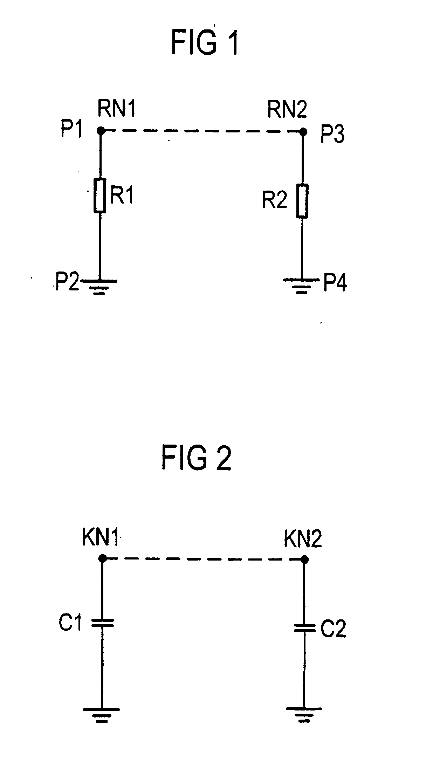

Figur 1 zeigt zwei Widerstands-Leitungsnetze RN1 und RN2. Das Widerstands-Leitungsnetz RN1 weist beispielsweise als eine Eratzschaltung einen einzigen Widerstand R1 und das Widerstands-Leitungsnetz RN2 weist ebenfalls als eine Ersatzschaltung einen einzigen Widerstand R2 auf. Dabei sei angenommen, das die Werte der Widerstände R1 und R2 gleich groß sind und jeweils 100 $\Omega$ betragen.

Die Widerstände R1 und R2 sind auf Masse geschaltet. Es kann aber auch angenommen werden, dass der hier als Bezugspunkt dienende Massepunkt auch ein auf einem Potential liegender Bezugspunkt sein kann. In den vorliegenden Erläuterungen wird daher dieser Punkt manchmal auch als Masse/Potential bezeichnet.

Weisen die beiden Leitungsnetze RN1 und RN2 an ihren dem Massepunkt gegenüberliegenden Seiten einen Kurzschluss auf, können bei Messungen an beiden Leitungsnetzen jeweils ein Widerstandswert von 50 $\Omega$ gemessen werden.

Der Kurzschluss ist in der Figur 1 durch eine gestrichelt gezeichnete Verbindungslinie zwischen den beiden Leitungsnetzen angedeutet. Für die Messung am Leitungsnetz RN1 sind die Punkte P1 und P2 zuständig. Für die Messung am Leitungsnetz RN2 sind die Punkte P2 und P4 zuständig.

Da davon auszugehen ist, dass der Aufbau einer zu testenden elektronischen Baugruppe bekannt ist, ist auch davon auszugehen, dass bekannt ist, welche Werte an welchen Stellen bei entsprechenden Messungen zu erhalten sind. Da im vorliegenden Fall aber statt 100 Ω nur 50 Ω gemessen wurden, ist damit bekannt, dass zwischen den Leitungsnetzen RN1 und RN2 ein Kurzschluss vorliegt.

Weisen die Widerstände R1 und R2 der beiden Leitungsnetze RN1 und RN2 unterschiedliche Widerstandswerte auf, ist die resultierende Veränderung durch den Kurzschluss am hochohmigen Leitungsnetz stärker. Bei großen Unterschieden der Widerstandswerte, beispielsweise wenn der Widerstandswert des Widerstandes R1 des Leitungsnetzes RN1 100 Ω und der Widerstand R2 des Leitungsnetzes RN2 10 kΩ beträgt, kann nur an dem Leitungsnetz RN2 mit dem hochohmigen Widerstand R2 eine signifikante Veränderung gemessen werden. Um die Diagnose der beiden Leitungsnetze dennoch zu ermöglichen, kann in diesem Fall zusätzlich ein bekanntes Verfahren mit dem Test benachbarter Leitungsnetze, das heißt eine Kurzschlussmessung zwischen den betreffenden benachbarten Leitungsnetzen durchgeführt werden.

Figur 2 zeigt ein Ausführungsbeispiel mit Leitungsnetzen KN1 und KN2, die keinen Widerstand auf Masse/Potential haben. Leitungsnetze KN1 und KN2 ohne Widerstand auf Masse/Potential werden messtechnisch durch Messungen der Netzkapazitäten C1 und C2 erfasst. Die Netzkapazitäten C1 und C2 ergeben sich aus:

$$C_N = I * C' + \text{PINZAHL} * C_{pin},$$

mit

| | |
|---|---|
| I | Leitungslänge |
| C' | Kapazität pro Längeneinheit (pf/cm) |
| PINZAHL | Anzahl der elektrischen Bauelemente am Leitunqsnetz |
| $C_{pin}$ | Kapazität der Bauelementeein- und -ausgänge. |
| N | Nummer des Leitungsnetzes bzw. der Netzkapazität |

Im vorliegenden Ausführungsbeispiel sei die Netzkapazität C1 des Leitungsnetzes KN1 30 pF und die Netzkapazität C2 des Leitungsnetzes KN2 40 pF.

Wird hier ein in der Figur 2 wieder durch eine gestrichelte Verbindungslinie zwischen den Leitungsnetzen KN1 und KN2 auf den der Masse/Potential-Anschlussseite gegenüberliegenden Seiten kenntlich gemachter Kurzschluss angenommen, werden an beiden Leitungsnetzen KN1 und KN2 Kapazitäten von 70 pF gemessen. Da aber bei den Leitungsnetzmessungen 30 pF und 40 pF erwartet werden, ist klar, dass zwischen den Leitungsnetzen KN1 und KN2 ein Kurzschluss vorliegt.

Um die Kurzschlüsse beispielsweise zwischen Leitungsnetzen mit Widerständen und Leitungsnetzen mit Kapazitäten zu erfassen, wird, ohne die aktuelle Kontaktierung zu lösen, neben der Kapazitätsmessung auch gleich ein Hochohmigkeitstest durchgeführt. Ergibt sich bei diesem Test beispielsweise ein Widerstandswert von > 100 kΩ, kann daraus abgeleitet werden, dass kein Kurzschluss zu einem anderen Leitungsnetz vorliegt.

Zusammenfassend kann damit bei Anwendung des vorgestellten Verfahrens bei Kurzschluss- und Bauelementetests auf einem Flying-Probe Tester folgendes gesagt werden.

a) Die Anzahl der Bewegungsschritte wird reduziert. Beispielsweise werden bei zu testenden elektrischen Baugruppen mit 500 Leitungsnetzen mit im Schnitt jeweils 5 benachbarten Leitungsnetzen im fehlerfreien Fall statt 2500 Bewegungsschritten nur mehr 500 Bewegungsschritte benötigt.

b) Es werden kürzere Wege bei der Bewegung der Kontaktierungselemente der Testmaschine erhalten. Bei geometrisch optimaler Reihenfolge der Leitungsnetztests liegt zwischen zwei Leitungsnetzen eine durchschnittliche Entfernung von 1 bis 2 cm vor.

c) Die Kontaktierungselemente der Testmaschine können besser ausgenutzt werden. Bei einer Testmaschine mit beispielsweise 4 Kontaktierungselemente können mit dem erfindungsgemäßen Verfahren gleichzeitig 3 Kontaktierungselemente eingesetzt werden. Ein Kontaktierungselement kontaktiert gemeinsam für die anderen Masse/Potential. Wird ein Test zwischen zwei benachbarten Leitungsnetzen durchgeführt, können gleichzeitig 2 Kontaktierungselementepaare die Messungen durchführen, wobei das Kontaktierungselement für Masse/Potential gleichzeitig für die eine und andere Messung dienen kann.

d) Die Tests an den Leitungsnetzen mit Widerständen haben eine doppelte Wirkung. Mit den Tests an diesen Leitungsnetzen werden gleichzeitig die Widerstandswerte und die Kurzschlussfreiheit am Leitungsnetz überprüft.

Deshalb wird die Anzahl der Testschritte beim Bauelementetest auf die Anzahl der Bauelemente reduziert, die keine Verbindung mit Masse/Potential haben.

Es besteht kein Bedarf mehr an der unter Umständen aufwendigen und doch in der Regel stets mit Kompromissen behafteten Bestimmung benachbarter Leitungsnetze, weil die Kurzschlussfreiheit zwischen jedem Leitungsnetz und allen jeweiligen anderen Leitungsnetzen auch mit dem vorgestellten Kurzschluss- und Bauelementetest sichergestellt werden kann.

Ohne erhebliche Verlängerung der Testzeit kann an jedem Leitungsnetz ein sogenannter Diodentest durchgeführt werden. Ein Diodentest ist ein Test auf Durchgang.

Die Testzeit für ein Leitungsnetz liegt beispielsweise bei 10 ms. Die Bewegungszeit der Kontaktierungselemente liegt beispielsweise im Bereich von 100 bis 200 ms/Leitungsnetz. Es ist daher besonders vorteilhaft, wenn Bewegungsschritte eingespart werden können. Falls zusätzlich Prüfschritte nötig werden sollten, fallen diese gegenüber der Bewegungszeit praktisch nicht ins Gewicht.

Voraussetzung für die Erkennung fehlender Bauelemente ist, dass mindestens ein Anschlussbeinchen am Bauelement ohne Verbindung mit weiteren Bauelementen vorhanden ist.

Für den Test der Kurzschlussfreiheit wird bei kapazitiven Leitungsnetzen die obere Grenze kontrolliert. Im Kurzschlussfall wird diese Grenze überschritten. Falls auch die untere Grenze getestet wird, können fehlende Bauelemente mit relativ hoher Pinkapazität, zum Beispiel 10 pF, sowie Unterbrechungen mit erheblichen Auswirkungen auf die Leitungsnetzkapazität abgedeckt werden.

**Patentansprüche**

1. Verfahren zum Testen von elektrische Bauelemente aufweisenden Baugruppen ohne Anschluss an eine Versorgungsspannung auf einer Testmaschine, Flying-Probe Tester, die zum Herstellen elektrischer Kontakte mit zu jeweiligen Leitungsnetzen der zu testenden Baugruppe gehörenden Kontaktpunkten nach allen Richtungen bewegbare Kontaktierungselemente aufweist, mit denen in einer Kurzschluss- und Bauelementetestphase nacheinander Gruppen von Kontaktpunkten der Baugruppen kontaktiert und zur Feststellung von Kurzschlüssen und fehlerhaften Bauelementen auf den elektrischen Baugruppen elektrische Größen gemessen werden, bei dem zu Beginn der Kurzschluss- und Bauelementetestphase mit den nacheinander stattfindenden Kontaktierungen von Gruppen von Kontaktpunkten (z.B. P1, P2; P3, P4) nacheinander Messungen an allen möglichen Leitungsnetzen (z.B. RN1, RN2) jeweils bezogen auf einen zugehörigen Masse/Potentialpunkt durchgeführt werden und bei dem Messungen an Leitungsnetzen mit Widerständen (z.B. R1, R2) und/oder Kapazitäten (z.B. C1, C2) und/oder Induktivitäten jeweils in zugehöriger Art Widerstands- und/oder Kapazitäts- und/oder Induktivitätswerte gemessen werden.

2. Verfahren nach Anspruch 1, **dadurch gekennzeichnet, dass** mit ergänzenden Kontaktierungen von Gruppen von Kontaktpunkten (z.B. P1, P3) Messungen zwischen Leitungsnetzen (z.B. RN1, RN2) durchgeführt werden, von denen das eine ein Leitungsnetz (z.B. RN1) ist, bei dessen vorausgegangener Messung zwischen diesem Leitungsnetz und dem zugehörigen Masse/Potentialpunkt ein signifikant anderer Wert als ein erwarteter gemessen worden ist, und das andere ein Leitungsnetz (z.B. RN2) ist, das zu dem einen Leitungsnetz auf der Baugruppe benachbart angeordnet ist.

3. Verfahren nach Anspruch 1 oder 2, **dadurch gekennzeichnet, dass** mit den Kontaktierungen von Gruppen von Kontaktpunkten (z.B. P2, P1, P3) Leitungsnetz-Masse/Potentialpunkt-Messungen an Leitungsnetzen (z.B. RN1, RN2) durchgeführt werden, die einen gemeinsamen zugehorigen Masse/Potentialpunkt und damit fur eine jeweilige Messung eine mögliche fixe Kontaktierung dieses gemeinsamen Punktes haben.

4. Verfahren nach einem der vorherigen Ansprüche, **dadurch gekennzeichnet, dass** bei Messungen zwischen einem Leitungsnetz (z.B. KN1) und einem zugehörigen Masse/Potentialpunkt, zwischen denen ausschließlich Kapazitäten (z.B. C1) angeordnet sind, außer einer Kapazitätsmessung zusätzlich auch eine Hochohmigkeitsmessung durchgeführt wird.

5. verfahren nach einem der vorherigen Ansprüche, **dadurch gekennzeichnet, dass** bei Messungen zwischen einem Leitungsnetz (z.B. KN1) und einem zugehörigen Masse/Potentialpunkt, zwischen denen ausschließlich Kapazitäten (z.B. C1) angeordnet sind, jeweils eine Messung auf einen erlaubten kapazitiven Höchstwert durchgeführt wird.

**6.** Verfahren nach einem der vorherigen Ansprüche, **dadurch gekennzeichnet, dass** bei Messungen zwischen einem Leitungsnetz (z.B. KN1) und einem zugehörigen Masse/Potentialpunkt, zwischen denen ausschließlich Kapazitäten (z.B. C1) angeordnet sind, jeweils eine Messung auf einen erlaubten kapazitiven Niedrigstwert durchgeführt wird.

**Claims**

**1.** A method of testing modules comprising electric components with no connection to a supply voltage on a test machine, a flying-probe tester, which, for establishing electric contacts with contact points in each case assigned to line networks of the module to be tested, comprises contacting elements which are moveable in all directions and with which, in a short-circuit- and component test phase, groups of contact points of the modules are successively contacted and, for the determination of short-circuits and defective components on the electric modules, electric quantities are measured, wherein at the start of the short-circuit- and component test phase, with the successively executed contacting of groups of contact points (e.g. P1, P2; P3, P4) measurements are performed successively on all possible line networks (e.g. RN1, RN2) in each case with reference to an associated ground/potential point, and wherein in the case of measurements on line networks comprising resistors (e.g. R1, R2) and/or capacitors (e.g. C1, C2) and/or inductances, resistive- and/or capacitive- and/or inductive values are measured in an associated manner.

**2.** A method according to Claim 1, **characterised in that** with supplementary contacting of groups of contact points (e.g. P1, P3), measurements are performed between line networks (e.g. RN1, RN2) of which one is a line network (e.g. RN1) in the case of which the previous measurement between this line network and the associated ground/potential point yielded a significantly different value from an expected value, and the other is a line network (e.g. RN2) arranged adjacent to the first line network on the module.

**3.** A method according to Claim 1 or 2, **characterised in that** with the contacting of groups of contact points (e.g. P2, P1, P3), line network-ground/potential point measurements are performed on line networks (e.g. RN1, RN2) which have a common associated ground/potential point and thus have a possible fixed contacting of this common point for a particular measurement.

**4.** A method according to one of the previous claims, **characterised in that** in the case of measurements between a line network (e.g. KN1) and an associated ground/potential point between which only capacitors (e.g. C1) are arranged, a high-impedance measurement is performed in addition to a capacitive measurement.

**5.** A method according to one of the previous claims, **characterised in that** in the case of measurements between a line network (e.g. KN1) and an associated ground/potential point between which only capacitors (e.g. C1) are arranged, a measurement for a maximum permitted capacitive value is in each case performed.

**6.** A method according to one of the preceding claims, **characterised in that** in the case of measurements between a line network (e.g. KN1) and an associated ground/potential point between which only capacitors (e.g. C1) are arranged, a measurement for a minimum permitted capacitive value is in each case performed.

**Revendications**

**1.** Procédé pour tester des modules comportant des composants électriques sans raccordement à une tension d'alimentation sur une machine de test, Flying-Probe Tester, qui comporte, pour établir des contacts électriques avec des points de contact appartenant à des réseaux de lignes respectifs du module à tester, des éléments de contact qui sont mobiles dans toutes les directions et avec lesquels, dans une phase de test de court-circuit et de composant, on met en contact les uns après les autres des groupes de points de contact des modules et on mesure des grandeurs électriques pour détecter des courts-circuits et des composants manquants sur les modules électriques, dans lequel, au début de la phase de test de court-circuit et de composant avec les mises en contact, ayant lieu successivement, de groupes de points de contact (par exemple P1, P2 ; P3, P4), on effectue successivement des mesures sur tous les réseaux de lignes possibles (par exemple RN1, RN2) à chaque fois par rapport à un point masse/potentiel associé et dans lequel on mesure, pour des mesures sur des réseaux de lignes avec résistances (par exemple R1, R2) et/ou avec capacités (par exemple C1, C2) et/ou avec inductances, à chaque fois et de manière appropriée des valeurs de résistances et/ou de capacités et/ou d'inductances.

**2.** Procédé selon la revendication 1, **caractérisé par le fait que**, avec des mises en contact complémentaires de groupes de points de contact (par exemple P1, P3), on effectue des mesures entre des réseaux de lignes (par exemple RN1, RN2) dont l'un est un réseau de lignes (par exemple RN1) lors de la mesure précédente duquel une valeur significativement différente d'une valeur attendue a été mesurée entre ce réseau de lignes et le point masse/potentiel associé et l'autre est un réseau de lignes (par exemple RN2) qui est voisin du premier réseau de lignes sur le module.

**3.** Procédé selon la revendication 1 ou 2, **caractérisé par le fait que**, avec les mises en contact de groupes de points de contact (par exemple P2, P1, P3), on effectue des mesures réseau de lignes - masse/potentiel sur des réseaux de lignes (par exemple RN1, RN2) qui ont un point masse/potentiel associé commun et donc, pour une mesure respective, une mise en contact fixe possible de ce point commun.

**4.** Procédé selon l'une des revendications précédentes, **caractérisé par le fait que**, lors de mesures entre un réseau de lignes (par exemple KN1) et un point masse/potentiel associé, entre lesquels sont agencées exclusivement des capacités (par exemple C1), on effectue outre une mesure de capacité en plus une mesure de haute impédance.

**5.** Procédé selon l'une des revendications précédentes, **caractérisé par le fait que**, lors de mesures entre un réseau de lignes (par exemple KN1) et un point masse/potentiel associé, entre lesquels sont agencées exclusivement des capacités (par exemple C1), on effectue à chaque fois une mesure par rapport à une valeur capacitive maximale autorisée.

**6.** Procédé selon l'une des revendications précédentes, **caractérisé par le fait que**, lors de mesures entre un réseau de lignes (par exemple KN1) et un point masse/potentiel associé, entre lesquels sont agencées exclusivement des capacités (par exemple C1), on effectue à chaque fois une mesure par rapport à une valeur capacitive minimale autorisée.

# FIG 1

RN1    RN2
P1 ●----------● P3

R1        R2

P2        P4

# FIG 2

KN1    KN2
●----------●

C1        C2